Europäisches Patentamt

European Patent Office

Office européen des brevets

(11) Publication number: **0 592 937 A2**

# EUROPEAN PATENT APPLICATION

(21) Application number: **93116195.4**

(22) Date of filing: **06.10.93**

(51) Int. Cl.5: **H01B 3/30**

(30) Priority: **12.10.92 JP 300435/92**

(43) Date of publication of application:
**20.04.94 Bulletin 94/16**

(84) Designated Contracting States:
**DE FR GB NL**

(71) Applicant: **NITTO DENKO CORPORATION**
**1-2, Shimohozumi 1-chome**
**Ibaraki-shi**
**Osaka(JP)**

(72) Inventor: **Ichikawa, Hiroki, c/o Nitto Denko**
**Corporation**
**1-2, Shimohozumi 1-chome**
**Ibaraki-shi, Osaka(JP)**
Inventor: **Okuno, Toshimitsu, c/o Nitto Denko**
**Corporation**
**1-2, Shimohozumi 1-chome**
**Ibaraki-shi, Osaka(JP)**
Inventor: **Aizawa, Kaoru, c/o Nitto Denko**
**Corporation**
**1-2, Shimohozumi 1-chome**
**Ibaraki-shi, Osaka(JP)**

(74) Representative: **Patentanwälte Grünecker,**
**Kinkeldey, Stockmair & Partner**
**Maximilianstrasse 58**
**D-80538 München (DE)**

(54) **Tracking resistant material and circuit substrate using the material.**

(57) A tracking resistant material wherein a carbonized product forming ratio [(energy necessary for forming the carbonized product)/(energy necessary for thermal decomposition)] is 0.45 or less, and comparative tracking indexes of the front surface and the back surface thereof by a tracking resistance test of an IEC method are at least 400 V.

EP 0 592 937 A2

## FIELD OF THE INVENTION

The present invention relates to a tracking resistant material and a circuit substrate using the material.

## BACKGROUND OF THE INVENTION

When electric parts are used under the conditions or the circumstances that electrically conductive liquids or ionic impurities are adhered to the parts, tracking occurs on the surface of an insulating material of the electric part, causing a danger of a fire.

Accordingly, the insulating material for the electric parts used under such conditions or circumstances as described above is an insulating material having an excellent tracking resistance. Usually, a tracking resistance test by an IEC method is used as a tracking test and an insulating material having the comparative tracking index in the tracking resistance test of at least about 400 V has been desired.

In the tracking phenomenon, carbonized paths grow on the surface of the insulating layer by repeating adhesion of an electrically conductive contaminating liquid onto the surface of an insulating material to which a surface electric stress acts, carbonization of the surface of the insulating material due to a joule heat of the adhered liquid layer generated by passing an electric current, cutting of the electric current paths by local drying of the adhered liquid layer at the portion of a large current density by the electric current passing, breakdown of the electric current passing, and readhesion of the electrically conductive contaminating liquid. In this case, if the time until the carbonized paths pass electric current to cause the surface insulation breakdown is prolonged, the electric current passing and the breakdown are repeated many times, whereby the surface of the insulating material is accumulately and deeply corroded by the carbonization.

However, if the comparative tracking index of the insulating material is at least 400 V, the corroded depth by the carbonization becomes deep and the carbonization tends to occur in the whole thickness of the insulating layer, whereby there is a possibility to cause the insulation breakdown of electric parts by the accumulation of the carbonized materials in the thickness direction.

On the other hand, only the surface of an insulating material has conventionally been considered. For example, in the case of a composite layer material, a material having an excellent tracking resistance is used for the surface layer only. Hence when the comparative tracking index of the surface layer is 400 V or higher, occurrence of the surface insulation breakdown can be prevented but it is difficult to prevent the insulation breakdown in the thickness direction.

## SUMMARY OF THE INVENTION

Accordingly, an object of the present invention is to provide a tracking resistant material which can restrain well both the insulation breakdown by carbonization along the surface and the insulation breakdown by carbonization in the thickness direction.

According to one embodiment of the present invention, there is provided a tracking resistant material, wherein a carbonised product forming ratio [(heat energy necessary for forming a carbonized product)/(energy necessary for thermal decomposition)] is 0.45 or less, and preferably from 0.1 to 0.43 and comparative tracking indexes of the front surface and the back surface thereof by the tracking resistance test in an IEC method are at least 400 V, and preferably at least 550 V.

According to another embodiment of the present invention, there is provided a tracking resistant material comprising a composite material of plural kinds of materials, wherein the total carbonized product forming ratio is 0.45 or less, and preferably from 0.1 to 0.43 and comparative tracking indexes of the front surface layer and the back surface layer by the tracking resistance test in an IEC method are at least 400 V, and preferably at least 550 V.

## DETAILED DESCRIPTION OF THE INVENTION

In the present invention, the comparative tracking indexes of the front surface layer and the back surface layer of tracking resistant material by the tracking resistance test in an IEC method are sufficiently high and the total carbonized product forming ratio c [if the carbonized product forming ratio of each material is $c_1$, $c_2$, ..., and the weight of each material is $w_1$, $w_2$, ..., $c = (c_1 w_1 + c_2 w_2 + ...)/(w_1 + w_2 + ...)$] are sufficiently small. Hence occurrence of the whole carbonization including both the surfaces and the inside of the tracking resistance material of the present invention can be prevented well and further occurrence of the tracking on the surface can be prevented well, whereby the surface insulation breakdown caused by the formation of the surface carbonized paths and the insulation breakdown in the thickness direction caused by carbonised corrosion in the thickness direction can be prevented well.

In the tracking resistant insulating material of the present invention, the carbonised product forming ratio is 0.45 or less, and preferably from 0.1 to 0.43 and the comparative tracking indexes of the front surface and the back surface by the tracking resistance test of an IEC method (a commercial frequency voltage is applied to a test piece, an aqueous solution of 0.1% ammonium chloride is dropped onto the test piece with an interval of 30 seconds, the dropped number when causing the surface electric passing breakage of the test piece is measured while increasing the voltage at a definite step, and the voltage at which the surface electric passing breakage occurs at the dropped number of 50 is defined as the comparative tracking index (hereinafter referred to as "CTI"). That is, the CTI value is at least 400 V, and preferably at least 550 V. The tracking resistant insulating material of the present invention may be composed of a single layer or a composite layer of plural layers.

In the case of a composite layer, the back surface layer can be composed of a hot melt adhesive layer (ethylene-vinyl acetate copolymer (EVA), ethylene-ethyl acrylate copolymer (EEA), polyethylene (PE), etc.) or a pressure-sensitive adhesive layer (acrylic, silicone type, or rubber type pressure-sensitive adhesive layer).

A single synthetic resin material can be used as the material which constitutes the single layer type tracking resistant insulating material or the composite layer type tracking resistant insulating material of the present invention, but by compounding the synthetic resin as the base material with other material, the carbonized product forming ratio of the whole insulating materials can be reduced to 0.45 or lower, and preferably to the value of from 0.1 to 0.43 and also the CTI values of the front surface layer and the back surface layer can be increased to at least 400 V, and preferably at least 550 V.

As other material which is compounded with the synthetic material as the base material, one or two or more kinds of inorganic materials such as magnesium hydroxide, aluminum hydroxide, metal carbonates, silica, glass fibers, antimony trioxide, etc., can be used.

In particular, in a laminate of a support film or sheet and a pressure-sensitive adhesive layer, it is difficult to increase the CTI value of the pressure-sensitive layer to 400 V by only the pressure-sensitive adhesive of the base material. Hence other inorganic material(s) described above are usually compounded with the pressure-sensitive adhesive layer.

The above-described embodiment which uses the construction of the composite layer includes laminated layers of films or sheets as well as other base materials such as woven fabrics, nonwoven fabrics, nets, etc., impregnated or coated with a resin (in this case, the resin includes a B stage resin).

If a carbonized path is formed by tracking, in the worst case, it sometimes happens that a short-circuit electric current passes through the carbonized path to cause a fire. Hence it is preferred that material constituting the layer is compounded with a flame retardant, such as a halogen type flame retardant, which does not impair the tracking resistance and the carbonized product forming ratio.

In addition, when the contaminating condition of the use environment of electric parts is severe, it is preferable that the carbonized product forming ratio is from 0.1 to 4.3 and/or the CTI value is at least 550 V.

The tracking resistant material of the present invention can be used for the insulation of various kinds of electric parts and is useful for the insulation of a circuit substrate wherein the thickness of the insulation coating cannot be increased from the construction of the electric part, and in particular for the insulation of a high-voltage circuit substrate wherein the working voltage is relatively high as from 50 to 1,000 V.

The tracking resistant material of the present invention can be also suitably used as an insulating adhesive tape or sheet which is a laminate material of a support film and an adhesive agent layer. In this case, the support film may be a single layer material or a laminated layer material.

The thickness of the tracking resistant material of the present invention is from 10 $\mu$m to 1,000 $\mu$m. In the case of employing a laminate structure of a support film and an adhesive layer, the thicknesses of the support film and the adhesive layer each is 500 $\mu$m or less.

The amount of the inorganic material compounded is from 5 to 150 parts by weight per 100 parts by weight of the base material. Further, the amount of the flame retardant compounded such as a halogen type flame retardant is from 5 to 100 parts by weight per 100 parts by weight of the base material.

The tracking resistant material of the present invention can be also used for the insulation between layers of various electric parts such as coils and is useful for the insulation of a circuit substrate wherein the thickness of the insulation coating cannot be increased from the construction thereof, and in particular, for the insulation of a high-voltage circuit substrate wherein the working voltage is relatively high as from 50 to 1,000 V.

The present invention is explained in more detail by reference to the following examples relating to the insulating adhesive tape, but is not limited to those examples.

Example 1

A laminate film formed by laminating a polypropylene film having a thickness of 15 μm and a polyester film having a thickness of 16 μm with a urethane adhesive (TAKELAC, trade name, manufactured by Takeda Chemical Industries, Ltd.) or a polyester adhesive (VYLON, trade name, manufactured by Toyo Boseki Co.) was used as a support. A flame retardant acrylic pressure-sensitive adhesive composed of 100 parts by weight of a main polymer (butyl acrylate-acrylic acid copolymer, 95:5 by weight), 50 parts by weight of a bromine type flame retardant (hexabromobenzene, bromine content: 86.9 wt%, melting point: 315°C), 30 parts by weight of antimony trioxide, and 1 part by weight of a polyisocyanate type crosslinking agent was coated on the polyester film surface of the support at a thickness of 20 μm.

The carbonized product forming ratio of the coated product in this example was calculated and was found to be 0.38 and the CTI values of the front surface and the back surface thereof were measured and were found to be at least 600 V.

Example 2

A composition obtained by compounding 100 parts by weight of an acrylurethane-modified resin (urethane acrylate) with 1 part by weight of a radical polymerization initiator (benzyl dimethyl ketal) and 10 parts by weight of silica was coated on the surface of a polyester film having a thickness of 25 μm followed by drying, and the coated film was irradiated with ultraviolet rays to form a surface layer having a thickness of 5 μm, thereby obtaining a support. An acrylic pressure-sensitive adhesive composed of 100 parts of a main polymer (butyl acrylate-acrylic acid copolymer), 50 parts by weight of aluminum hydroxide and 1 part by weight of a polyisocyanate type crosslinking agent was coated on the polyester film surface of the support at a thickness of 20 μm.

The carbonized product forming ratio of the coated product was calculated and was found to be 0.34 and the CTI values of the front surface and the back surface thereof were measured and were found to be at least 600 V.

Example 3

A polyisocyanate type adhesive was coated on a polyester film having a thickness of 23 μm and a polyethylene layer having a thickness of 10 μm was then formed thereon by a melt extrusion to obtain a support. An adhesive obtained by compounding 100 parts by weight of a silicon polymer (a mixture of polydimethylsiloxane and benzoyl peroxide) with 50 parts by weight of silica was coated on the polyester film surface of the support at a thickness of 30 μm.

The carbonized product forming ratio of the coated product was calculated and was found to be 0.35 and the CTI values of the front surface and the back surface thereof were measured and were found to be at least 600 V.

Since the tracking resistant material of the present invention has the construction as described above, the comparative tracking indexes of the front surface and the back surface thereof by the tracking resistance test of an IEC method are high as at least 400 V, and also the whole carbonized product forming ratio is low as 0.45 or lower, carbonization is difficult to cause not only on the surface of the insulating material but also on the back surface and the inside thereof and further when the tracking resistant material of the present invention is exposed to contaminating circumstances, not only occurrence of the surface electric current passing insulation breakdown by carbonization but also occurrence of the insulation breakdown in the thickness direction by carbonized corrosion in the thickness direction can be prevented well.

While the invention has been described in detail and with reference to specific embodiments thereof, it will be apparent to one skilled in the art that various changes and modifications can be made therein without departing from the spirits and scope thereof.

**Claims**

1. A tracking resistant material wherein a carbonized product forming ratio [(energy necessary for forming the carbonized product)/(energy necessary for thermal decomposition)] is 0.45 or less, and comparative tracking indexes of the front surface and the back surface thereof by a tracking resistance test of an IEC method are at least 400 V.

2. The tracking resistant material of claim 1, wherein the carbonized product forming ratio is from 0.1 to 0.43.

3. The tracking resistant material of claim 1, wherein the comparative tracking indexes are at least 550 V.

4. A tracking resistant material comprising a composite material composed of plural kinds of materials, wherein the whole carbonized product forming ratio is 0.45 or less and comparative tracking indexes of the front surface layer and the back surface layer thereof by a tracking resistance test of an IEC method are at least 400 V.

5. The tracking resistant material of claim 4, wherein the whole carbonized product forming ratio is from 0.1 to 0.43.

6. The tracking resistant material of claim 4, wherein the comparative tracking indexes are at least 550 V.

7. The tracking resistant material of claim 4, wherein the surface layer is composed of a synthetic resin alone or a synthetic resin compounded with other compounding agent(s).

8. The tracking resistant material of claim 7, wherein the other compounding agent(s) are inorganic materials.

9. The tracking resistant material of claim 8, wherein the inorganic material is at least one selected from the group consisting of magnesium hydroxide, aluminum hydroxide, metal carbonates, silica, glass fibers, and antimony trioxide.

10. The tracking resistant material of claim 7, wherein the other compound agent is a halogen type flame retardant.

11. The tracking resistant material of claim 4, wherein the back layer is an adhesive layer composed of a synthetic resin alone or a synthetic resin compounded with other compounding agent(s).

12. The tracking resistant material of claim 11, wherein the adhesive layer is a pressure-sensitive adhesive layer.

13. The tracking resistant material of claim 11, wherein other compounding agent(s) are inorganic materials.

14. The tracking resistant material of claim 13, wherein the inorganic material is at least one selected from the group consisting of magnesium hydroxide, aluminum hydroxide, metal carbonates, silica, glass fibers, and antimony trioxide.

15. The tracking resistant material of claim 11, wherein the other compounding agent is a halogen type flame retardant.

16. The tracking resistant material of claim 4, wherein the composite material is composed of at least 3 layers and the layer(s) other than the front surface layer and the back surface layer are composed of a synthetic resin alone.

17. A circuit substrate having a working voltage of from 50 to 1,000 V, comprising the tracking resistant material of claim 1.